# FASCICULE DE BREVET EUROPEEN

(11) **EP 4 611 503 B1**
(45) Date de publication et mention de la délivrance du brevet: **05.08.2026**
(21) Numéro de dépôt: 25159005.5
(22) Date de dépôt: 20.02.2025
(51) Int. Cl.: H10D 18/80, H10D 62/10, H10D 62/13

(54) **COMPOSANT ELECTRONIQUE**
ELEKTRONISCHES BAUELEMENT
ELECTRONIC COMPONENT

(30) Priorité: 28.02.2024 FR 2401932
(43) Date de publication de la demande: 03.09.2025
(73) Titulaire: STMicroelectronics International N.V., 1228 Plan-les-Ouates, Geneva (CH)
(72) Inventeur: MAURIAC, Christophe, 37250 MONTBAZON (FR); SIEGERT, Laurent, 37390 LA MEMBROLLE SUR CHOISILLE (FR)
(74) Mandataire: Cabinet Beaumont

(56) Documents cités:
- JP-U- H04 107 859
- US-A- 4 903 105

## Description

### Domaine technique

La présente description concerne de façon générale les composants électroniques, plus particulièrement les triacs.

### Technique antérieure

De nombreux composants électroniques ont été proposés. Parmi ces composants électroniques, des triacs (de l'anglais « triode for alternating current ») ont plus particulièrement été proposés.

Le document JP H04 107859 U divulgue un triac comprenant, du côté de la face supérieure du substrat, une première région dopée N connectée à une première borne de conduction et, du côté de la face inférieure du substrat, une deuxième région dopée N connectée à une deuxième borne de conduction, ainsi qu'une région de gâchette. Les première et deuxième régions dopées N présentent respectivement des surfaces latérales parallèles. Le triac selon JP H04 107859 U comprend en outre, entre lesdites surfaces latérales parallèles, une région de séparation non couverte par lesdites régions dopées N. Ladite région de séparation présente la forme d'une bande s'étendant le long d'une première direction correspondant à la diagonale du dispositif en vue de dessus.

Toutefois, les composants électroniques existants, en particulier les triacs existants, sont affectés par divers inconvénients.

### Résumé de l'invention

Il existe un besoin de pallier tout ou partie des inconvénients des composants électroniques, en particulier des triacs, existants.

Pour cela, un mode de réalisation prévoit un triac formé dans et sur un substrat semiconducteur, le triac présentant, en vue de dessus, une forme sensiblement rectangulaire et comprenant :
- du côté d'une première face du substrat, une première région dopée d'un premier type de conductivité et connectée à une première borne de conduction du triac ;
- du côté d'une deuxième face du substrat opposée à la première face, une deuxième région dopée du premier type de conductivité et connectée à une deuxième borne de conduction du triac ; et
- une région de gâchette connectée à une borne de commande du triac,
dans lequel les première et deuxième régions présentent respectivement des première et deuxième faces latérales parallèles, le triac comprenant, entre les première et deuxième faces latérales parallèles, une région de séparation non recouverte par les première et deuxième régions, la région de séparation ayant la forme d'une bande s'étendant le long d'une première direction à l'intérieur de la région de gâchette et présentant une inflexion à l'extérieur de la région de gâchette, dans lequel la première direction est inclinée d'un angle égal à environ 45° par rapport aux côtés du rectangle formé par le triac.

Selon un mode de réalisation, la région de séparation a, à l'extérieur de la région de gâchette, la forme d'une bande s'étendant le long d'une deuxième direction sensiblement parallèle à une diagonale du rectangle formé par le triac.

Selon un mode de réalisation, un réseau de court-circuitage est formé dans chacune des première et deuxième régions, chaque réseau de court-circuitage comprenant au moins une tranchée traversante s'étendant le long d'une troisième direction à l'intérieur de la région de gâchette et présentant une inflexion à l'extérieur de la région de gâchette.

Selon un mode de réalisation, la troisième direction est sensiblement parallèle à la première direction.

Selon un mode de réalisation, à l'extérieur de la région de gâchette, chaque tranchée traversante s'étend le long d'une quatrième direction sensiblement parallèle à une diagonale du rectangle formé par le triac.

Selon un mode de réalisation, chaque réseau de court-circuitage comprend en outre une pluralité de vias traversants.

Selon un mode de réalisation, la région de gâchette présente, en vue de dessus, une forme sensiblement carrée.

Selon un mode de réalisation, le substrat semiconducteur est dopé d'un deuxième type de conductivité opposé au premier type de conductivité, les premier et deuxième types de conductivité étant respectivement le type N et le type P.

Un mode de réalisation prévoit un dispositif comprenant au moins un triac tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de côté et en coupe, schématique et partielle, d'un exemple de triac selon un mode de réalisation non revendiqué ;
la figure 2 est un schéma électrique équivalent du triac de la figure 1 ;
la figure 3 est une vue de dessus, schématique et partielle, d'un exemple de triac selon un mode de réalisation non revendiqué ;
la figure 4 est une vue de dessus, schématique et partielle, d'un autre exemple de triac selon un mode de réalisation selon l'invention ; et
la figure 5 est un schéma-bloc illustrant, de façon schématique et partielle, un exemple de dispositif comprenant le triac de la figure 4 selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications des triacs n'ont pas été détaillées, les modes de réalisation décrits étant compatibles avec toutes ou la plupart des applications des triacs, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près, ou, s'il s'agit de valeurs angulaires, à 10° près, de préférence à 5° près.

Dans la description qui suit, les qualificatifs « isolant » et « conducteur » signifient respectivement, sauf précision contraire, électriquement isolant et électriquement conducteur.

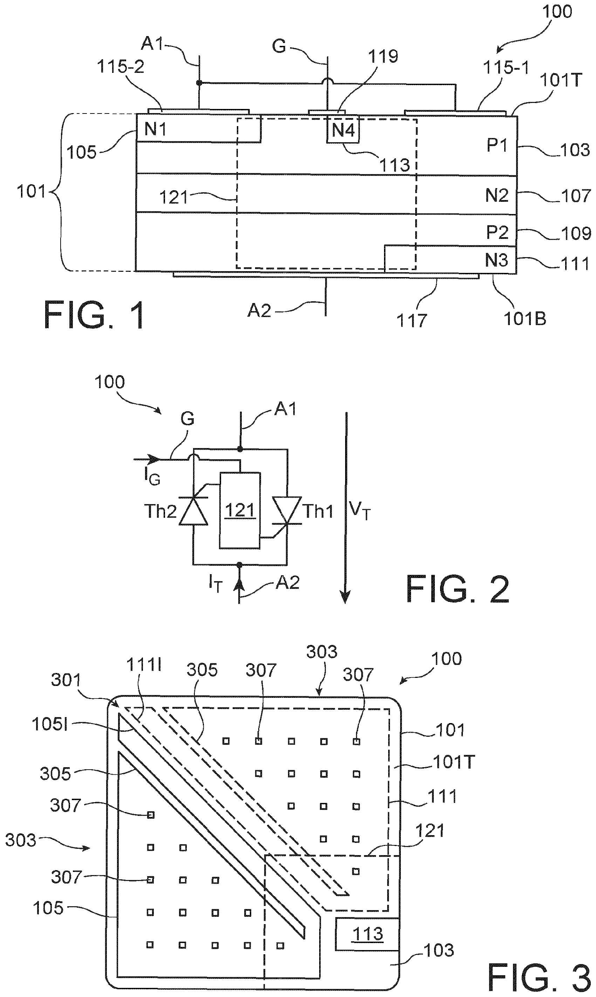

La figure 1 est une vue de côté et en coupe, schématique et partielle, d'un exemple de triac (de l'anglais « triode for alternating current » - triode pour courant alternatif) 100 selon un mode de réalisation non revendiqué.

Dans l'exemple représenté, le triac 100 est formé dans et sur un substrat semiconducteur 101. Le substrat 101 est par exemple une plaquette ou un morceau de plaquette en un matériau semiconducteur, par exemple le silicium.

Dans l'exemple illustré, le triac 100 comprend une région semiconductrice 103 (P1) dopée d'un premier type de conductivité, par exemple le type P, formée dans le substrat semiconducteur 101. Dans cet exemple, la région 103 s'étend dans l'épaisseur du substrat semiconducteur 101 depuis une face 101T du substrat semiconducteur 101 (la face supérieure du substrat semiconducteur 101, dans l'orientation de la figure 1).

Dans l'exemple représenté, le triac 100 comprend en outre, du côté de la face 101T du substrat semiconducteur 101, une région semiconductrice 105 (N1) dopée d'un deuxième type de conductivité opposé au premier type de conductivité, c'est-à-dire dopée du type N, dans cet exemple. La région 105 est formée dans la région 103 et s'étend dans l'épaisseur du substrat semiconducteur 101 depuis sa face 101T jusqu'à une profondeur inférieure à celle de la région 103. Dans l'exemple illustré, la région 105 est ainsi au moins partiellement entourée, ou bordée, par la région 103. Dans l'orientation de la figure 1, le matériau de la région 103 revêt au moins certaines faces latérales et une face inférieure, ou un fond, de la région 105.

Dans l'exemple illustré, le triac 100 comprend en outre une autre région semiconductrice 107 (N2) dopée du deuxième type de conductivité, c'est-à-dire dopée du type N, dans cet exemple. Dans cet exemple, la région 107 est située du côté d'une face de la région 103 opposée à la face 101T du substrat semiconducteur 101 (du côté de la face inférieure de la région 103, dans l'orientation de la figure 1). Dans l'exemple représenté, la région 107 est située sous et en contact avec la région 103.

Dans l'exemple représenté, le triac 100 comprend en outre une autre région semiconductrice 109 (P2) dopée du premier type de conductivité, c'est-à-dire dopée du type P, dans cet exemple. Dans cet exemple, la région 109 est située du côté d'une face de la région 107 opposée à la région 103 (du côté de la face inférieure de la région 107, dans l'orientation de la figure 1). Dans l'exemple représenté, la région 109 est située sous et en contact avec la région 107. Dans l'exemple illustré, la région 109 s'étend verticalement dans l'épaisseur du substrat semiconducteur 101 depuis une autre face 101B du substrat semiconducteur 101 opposée à la face 101T (la face inférieure du substrat semiconducteur 101, dans l'orientation de la figure 1).

Dans l'exemple représenté, le triac 100 comprend en outre, du côté de la face 101B du substrat semiconducteur 101, encore une autre région semiconductrice 111 (N3) dopée du deuxième type de conductivité, c'est-à-dire dopée du type N, dans cet exemple. La région 111 est formée dans la région 109 et s'étend dans l'épaisseur du substrat semiconducteur 101 depuis sa face 101B jusqu'à une profondeur inférieure à celle de la région 109. Dans l'exemple illustré, la région 111 est ainsi au moins partiellement entourée, ou bordée, par la région 109. Dans l'orientation de la figure 1, le matériau de la région 109 revêt au moins certaines faces latérales et une face supérieure de la région 111. Dans l'exemple représenté, la région 111 n'est pas située à l'aplomb de la région 105.

Dans l'exemple illustré, le triac 100 comprend en outre encore une autre région semiconductrice 113 (N4) dopée du deuxième type de conductivité, c'est-à-dire dopée du type N, dans cet exemple. La région 113 est formée dans la région 103 et s'étend dans l'épaisseur du substrat semiconducteur 101 depuis sa face 101T jusqu'à une profondeur inférieure à celle de la région 103. La région 113 est disjointe de la région 105 et présente par exemple une hauteur, ou profondeur, sensiblement égale à celle de la région 105. Dans l'exemple illustré, la région 113 est ainsi au moins partiellement entourée, ou bordée, par la région 103. Dans l'orientation de la figure 1, le matériau de la région 103 revêt toutes les faces latérales et une face inférieure, ou un fond, de la région 113. Dans l'exemple représenté, la région 113 n'est pas située à l'aplomb de la région 111. Toutefois, cet exemple n'est pas limitatif et la région 113 peut, à titre de variante, être située à l'aplomb de la région 111.

À titre d'exemple, le substrat semiconducteur 101 est dopé du premier type de conductivité, c'est-à-dire du type P, dans cet exemple, et les régions 105, 107, 111 et 113 sont formées par diffusion, dans le substrat semiconducteur 101, d'espèces dopantes du deuxième type de conductivité, c'est-à-dire du type N, dans cet exemple.

Dans l'exemple représenté, le triac 100 comprend une première borne de conduction, aussi appelée première anode (A1), connectée aux régions 103 et 105. Dans cet exemple, la borne de conduction A1 comprend une électrode 115-1 s'étendant latéralement sur et en contact avec une partie de la face de la région 103 affleurant la face 101T du substrat semiconducteur 101 (la face supérieure de la région 103, dans l'orientation de la figure 1). La borne de conduction A1 comprend par exemple en outre une autre électrode 115-2 s'étendant latéralement sur et en contact avec une partie de la face de la région 105 affleurant la face 101T du substrat semiconducteur 101 (la face supérieure de la région 105, dans l'orientation de la figure 1). Les électrodes 115-1 et 115-2 sont par exemple disjointes et interconnectées électriquement par un circuit externe. À titre de variante, les électrodes 115-1 et 115-2 peuvent former une unique électrode.

Dans l'exemple illustré, le triac 100 comprend en outre une deuxième borne de conduction, aussi appelée deuxième anode (A2), connectée aux régions 109 et 111. Dans cet exemple, la borne de conduction A2 comprend une électrode 117 s'étendant latéralement sur et en contact avec une partie de la face de la région 109 affleurant la face 101B du substrat semiconducteur 101 (la face inférieure de la région 109, dans l'orientation de la figure 1). L'électrode 117 s'étend en outre sur et en contact avec une partie de la face de la région 111 affleurant la face 101B du substrat semiconducteur 101 (la face inférieure de la région 111, dans l'orientation de la figure 1).

Dans l'exemple représenté, le triac 100 comprend en outre une borne de gâchette (G) connectée aux régions 103 et 113. Dans cet exemple, la borne de gâchette G comprend une électrode 119 s'étendant latéralement sur et en contact avec une partie de la face de la région 103 affleurant la face 101T du substrat semiconducteur 101 (la face supérieure de la région 103, dans l'orientation de la figure 1). L'électrode 119 s'étend en outre sur et en contact avec une partie de la face de la région 113 affleurant la face 101T du substrat semiconducteur 101 (la face supérieure de la région 113, dans l'orientation de la figure 1).

À titre d'exemple, les électrodes 115-1, 115-2, 117 et 119 sont chacune en un matériau conducteur, par exemple un métal ou un alliage métallique. Par ailleurs, chaque électrode 115-1, 115-2, 117, 119 peut présenter une structure monocouche ou multicouche.

Dans l'exemple représenté, le triac 100 comprend une région de gâchette 121 symbolisée par un rectangle en trait pointillé en figure 1. La région de gâchette 121 du triac 100 s'étend dans le substrat semiconducteur 101 sensiblement à l'aplomb de l'électrode 119 de la borne de gâchette G, sous la région 113. Dans l'exemple illustré, la région de gâchette 121 comprend une gâchette du triac 100, comportant par exemple des parties des régions semiconductrices 103 et 113 situées à l'aplomb de l'électrode 119, et une zone primaire d'amorçage du triac 100. Dans cet exemple, la zone primaire d'amorçage du triac 100 s'étend latéralement depuis la gâchette et s'étend verticalement, depuis la gâchette, jusqu'à l'électrode 117.

La figure 2 est un schéma électrique équivalent du triac 100 de la figure 1.

Dans l'exemple représenté, le triac 100 est symbolisé par deux thyristors Th1 et Th2 montés tête-bêche en parallèle entre les bornes de conduction A1 et A2. Dans le schéma de la figure 2, les thyristors Th1 et Th2 présentent des bornes de gâchette connectées, par la région de gâchette 121, à la borne de gâchette G.

Le thyristor Th1 comprend par exemple un empilement comportant des parties des régions 103, 107, 109 et 111 situées sensiblement à l'aplomb de l'électrode 115-1 (à droite de la région de gâchette 121, dans l'orientation de la figure 1). Les électrodes 115-1 et 117 constituent par exemple respectivement des électrodes d'anode et de cathode du thyristor Th1.

De façon analogue, le thyristor Th2 comprend par exemple un empilement comportant des parties des régions 105, 103, 107 et 109 situées sensiblement à l'aplomb de l'électrode 115-2 (à gauche de la région de gâchette 121, dans l'orientation de la figure 1). Les électrodes 115-2 et 117 constituent par exemple respectivement des électrodes de cathode et d'anode du thyristor Th2.

Dans l'exemple illustré en figure 2, une tension V_{T} est présente entre les bornes de conduction A2 et A1 du triac 100. La tension V_{T} est par exemple appliquée par une source d'énergie électrique externe au triac 100, non représentée en figure 2. Par ailleurs, dans cet exemple, un courant de commande ou de gâchette I_{G} circule depuis la borne de gâchette G vers la région de gâchette 121.

Lorsque le courant de commande I_{G} est sensiblement nul, le triac 100 est dans un état bloqué empêchant la circulation d'un courant I_{T} entre ses bornes de conduction A2 et A1.

Depuis l'état bloqué, lorsque le courant de commande I_{G} devient supérieur, en valeur absolue, à un seuil de déclenchement I_{GT} (« gate threshold current », en anglais), par exemple sous l'effet de l'application d'une impulsion de courant de commande I_{G}, le triac 100 commute alors vers un état passant. À l'état passant, le courant I_{T} est libre de circuler entre les bornes de conduction A2 et A1. Lorsque le courant de commande I_{G} redevient inférieur au seuil de déclenchement I_{GT}, par exemple à la fin de l'impulsion de courant de commande I_{G}, le triac 100 reste à l'état passant tant que le courant I_{T} demeure, en valeur absolue, supérieur à un seuil de verrouillage I_{L} (« latching current », en anglais) du triac 100. En particulier, si l'impulsion de courant de commande I_{G} présente une durée suffisante pour permettre au triac 100 d'achever la commutation vers l'état passant, par exemple une durée de l'ordre de quelques dizaines de microsecondes, le seuil de verrouillage I_{L} présente alors une valeur minimale correspondant à un seuil de maintien I_{H} (« holding current », en anglais). Le seuil de maintien I_{H} correspond à la valeur minimale du courant I_{T} requise pour maintenir le triac 100 à l'état passant.

Lorsque le courant I_{T} devient inférieur, en valeur absolue, au seuil de maintien I_{H}, le triac 100 commute alors depuis l'état passant vers l'état bloqué.

En pratique, les seuils de déclenchement I_{GT}, de verrouillage I_{L} et de maintien I_{H} peuvent, en valeur absolue, prendre des valeurs distinctes selon que le courant de commande I_{G} est positif ou négatif, et/ou selon que la tension V_{T} est positive ou négative.

Le triac 100 présente une sensibilité dépendant de la valeur de son seuil de déclenchement I_{GT}. Plus la valeur du seuil de déclenchement I_{GT} est faible, plus le triac 100 est dit sensible.

Les performances électriques du triac 100 dépendent en outre de divers autres paramètres, désignés par les expressions dv/dt, di/dt, (di/dt)_{c}, etc. Ces paramètres sont fortement liés aux caractéristiques, en particulier à la géométrie et aux dimensions, de la région de gâchette 121. Dit autrement, de légères modifications de la région de gâchette 121 provoquent d'importantes modifications des performances électriques du triac 100.

La figure 3 est une vue de dessus, schématique et partielle, du triac 100. Dans l'exemple représenté, le triac 100 présente une forme générale sensiblement carrée. À titre d'exemple, le carré formé par le triac 100 présente un côté de l'ordre de quelques millimètres, par exemple égal à environ 2 ou 3 mm. Le triac 100 est par exemple capable de supporter, à l'état passant, un courant nominal de l'ordre de 16 à 20 A.

Dans l'exemple illustré, la région semiconductrice 105 et la région semiconductrice 111 présentent, en vue de dessus, des surfaces sensiblement égales. Cela permet notamment de faire en sorte que les thyristors Th1 et Th2 présentent des caractéristiques électriques sensiblement identiques.

Par ailleurs, dans cet exemple, les régions 105 et 111 ne se recouvrent pas, c'est-à-dire que la région 105 ne s'étend pas latéralement à l'aplomb de la région 111. Cela permet notamment de faire en sorte que les thyristors Th1 et Th2 puissent être commandés indépendamment l'un de l'autre.

À titre d'exemple, chaque région 105, 111 présente une surface égale à environ la moitié d'une surface correspondant à la surface totale du triac 100 moins la surface de la région 113. Dans l'exemple représenté où le triac 100 présente une forme générale carrée, les régions 105 et 111 présentent par exemple chacune une forme générale sensiblement triangulaire.

Dans l'exemple représenté, la région de gâchette 121, symbolisée, en figure 3, par un carré en pointillé entourant la région semiconductrice 113, est située au voisinage d'un premier coin du carré formé par le triac 100 (le coin inférieur droit, dans l'orientation de la figure 3). La région de gâchette 121 comprend la région 113 et des parties des régions 105 et 111 situées au voisinage du premier coin.

Dans l'exemple illustré, les régions 105 et 111 présentent respectivement des faces latérales parallèles 105I et 111I. Les faces 105I et 111I sont par exemple sensiblement verticales. Dans cet exemple, le triac 100 comprend, entre les faces latérales parallèles 105I et 111I, une région de séparation 301 non recouverte par les régions 105 et 111. Dit autrement, la région 301 ne s'étend pas à l'aplomb des régions 105 et 111.

Dans l'exemple illustré, la région de séparation 301 a la forme d'une bande sensiblement rectiligne s'étendant le long d'une direction sensiblement parallèle à une diagonale du carré formé par le triac 100. Dans l'exemple représenté, la région de séparation 301 s'étend plus précisément le long d'une diagonale du carré formé par le triac 100 reliant le premier coin à un deuxième coin du carré, diagonalement opposé au premier coin. Dans cet exemple, les faces latérales 1051 et 111I des régions 105 et 111 sont, en vue de dessus, inclinés d'un angle égal à environ 45° par rapport aux côtés du carré formé par le triac 100, la direction selon laquelle s'étend la région de séparation 301 étant inclinée d'un angle égal à environ 45° par rapport aux côtés du carré.

Dans l'exemple illustré, un réseau de court-circuitage 303 (« short network », en anglais) est formé dans chacune des régions 105, 111. À titre d'exemple, chaque réseau 303 comporte au moins une tranchée 305 formée dans la région 105 ou 111. Dans l'exemple représenté, chaque tranchée 305 est traversante, c'est-à-dire qu'elle s'étend à travers toute l'épaisseur de la région 105, 111 dans laquelle elle est formée.

Dans l'exemple représenté, la région 105 comporte une tranchée 305 s'étendant latéralement le long d'une direction sensiblement parallèle au côté 105I de la région 105. De façon analogue, la région 111 comporte, dans cet exemple, une tranchée 305 s'étendant latéralement le long d'une direction sensiblement parallèle au côté 111I de la région 111. Dans l'exemple illustré, chaque tranchée 305 est sensiblement rectiligne sur toute sa longueur. Dans l'exemple représenté, chaque tranchée 305 s'étend le long d'une direction inclinée d'un angle égal à environ 45° par rapport aux côtés du carré formé par le triac 100. Chaque tranchée 305 peut, comme dans l'exemple illustré en figure 3, déboucher sur un côté de la région 105 ou 111 différent du côté 105I ou 111I, par exemple au voisinage du deuxième coin du carré formé par le triac 100.

Chaque réseau 303 comporte par exemple en outre des vias 307 formés dans la région 105 ou 111. Dans l'exemple représenté, chaque via 307 est traversant, c'est-à-dire qu'il s'étend à travers toute l'épaisseur de la région 105, 111 dans laquelle il est formé. Dans l'exemple illustré, les vias 307 sont organisés en matrice selon des lignes et des colonnes, par exemple à pas constant, c'est-à-dire à distance centre à centre entre deux vias 307 adjacents constante. Les vias 307 peuvent présenter une section de forme quelconque, par exemple rectangulaire, ovale, carrée, circulaire, etc.

Dans l'exemple représenté, chaque tranchée 305 et chaque via 307 est rempli du matériau de la région 103, pour la ou les tranchées 305 et le ou les vias 307 formés dans la région 105, ou du matériau de la région 109, pour la ou les tranchées 305 et le ou les vias 307 formés dans la région 111.

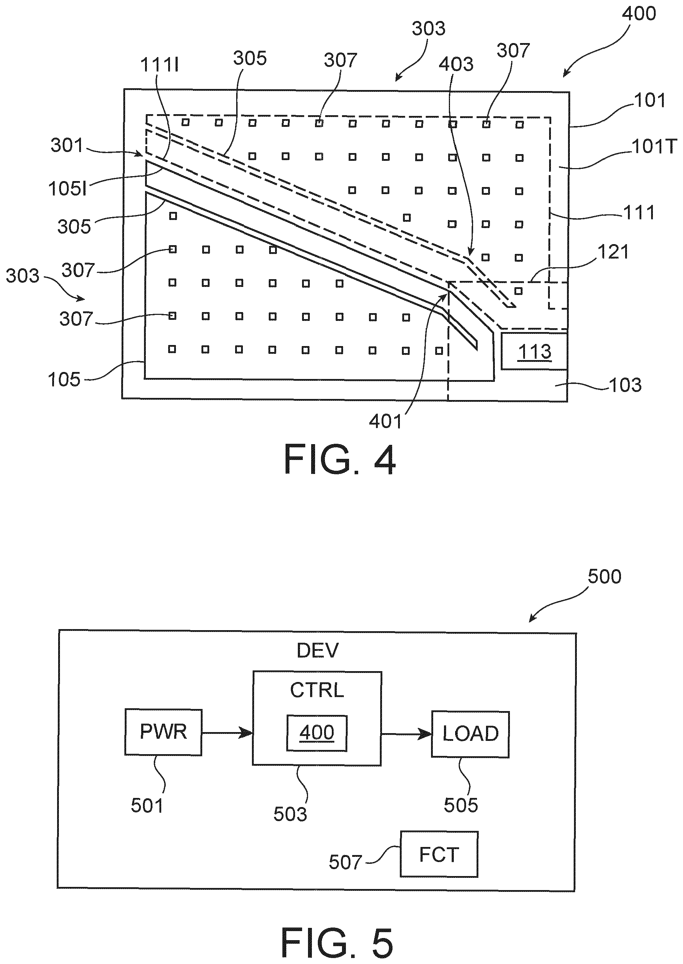

La figure 4 est une vue de dessus, schématique et partielle, d'un autre exemple de triac 400 selon un mode de réalisation.

Le triac 400 de la figure 4 comprend des éléments en commun avec le triac 100 de la figure 3. Ces éléments communs ne seront pas détaillés à nouveau ci-après.

Le triac 400 de la figure 4 diffère du triac 100 de la figure 3 en ce que, selon un mode de réalisation, la région de séparation 301 du triac 400 présente une inflexion 401 à l'extérieur de la région de gâchette 121. Selon ce mode de réalisation, la région de séparation 301 du triac 400 a la forme d'une bande s'étendant le long d'une première direction, à l'intérieur de la région de gâchette 121, et s'étendant selon une deuxième direction, non colinéaire à la première direction, à l'extérieur de la région de gâchette 121.

selon l'invention, le triac 400 présente une forme générale sensiblement rectangulaire. Selon l'invention, la première direction est inclinée d'un angle sensiblement égal à 45° par rapport aux côtés du rectangle formé par le triac 400. La deuxième direction est sensiblement parallèle à une diagonale du rectangle formé par le triac 400. Dans l'exemple illustré, la deuxième direction est sensiblement parallèle à la diagonale reliant un premier coin du rectangle formé par le triac 400, au voisinage duquel est située la région 113, à un deuxième coin diagonalement opposé au premier coin.

Par ailleurs, dans cet exemple, les tranchées 305 formées dans les régions 105 et 111 s'étendent le long d'une troisième direction, à l'intérieur de la région de gâchette 121, et présentant une inflexion 403 à l'extérieur de la région de gâchette 121. Dans l'exemple illustré, les tranchées 305 s'étendent selon une quatrième direction, non colinéaire à la troisième direction, à l'extérieur de la région de gâchette 121. Les troisième et quatrième directions sont par exemple respectivement parallèles aux première et deuxième directions. Dans l'exemple représenté, la troisième direction est inclinée d'un angle sensiblement égal à 45° par rapport aux côtés du rectangle formé par le triac 400, et la quatrième direction est sensiblement parallèle à la diagonale reliant les premier et deuxième coins du rectangle formé par le triac 400.

Un avantage du triac 400 tient au fait que l'inflexion 401 permet de ne pas modifier la structure de la région de gâchette 121 par rapport au triac 100. Le triac 400 présente ainsi par exemple des caractéristiques électriques identiques ou analogues à celles du triac 100. À titre d'exemple, le triac 400 présente un seuil de déclenchement I_{GT}, un seuil de verrouillage I_{L}, et un seuil de maintien I_{H} sensiblement égaux à ceux du triac 100. Le triac 400 présente par exemple en outre des performances dynamiques, caractérisées par les paramètres dv/dt, di/dt, (di/dt)_{c}, etc., sensiblement égales à celles du triac 100. D'un point de vue des caractéristiques électriques, le triac 400 diffère par exemple du triac 100 en ce que le triac 400 présente un calibre supérieur à celui du triac 100, le triac 400 étant, dans ce cas, capable de supporter un courant nominal supérieur au triac 100.

L'inflexion 401 permet en outre avantageusement de conserver des régions semiconductrices 105 et 111 présentant des surfaces sensiblement égales, donc des thyristors Th1 et Th2 présentant des caractéristiques électriques sensiblement identiques.

La figure 5 est un schéma-bloc illustrant, de façon schématique et partielle, un exemple de dispositif 500 (DEV) comprenant le triac 400 de la figure 4 selon un mode de réalisation.

Dans l'exemple représenté, le dispositif 500 comprend une source d'énergie électrique 501 (PWR). La source d'énergie électrique 501 est par exemple obtenue par branchement, ou raccordement, du dispositif 500 à un réseau de distribution d'énergie électrique, par exemple un réseau de distribution de courant alternatif monophasé ou triphasé. À titre de variante, la source d'énergie électrique 501 peut être une batterie embarquée dans le dispositif 500, la source 501 fournissant par exemple alors un courant continu. Dans ce cas, le courant fourni par la source 501 est par exemple converti en courant alternatif par un onduleur (non représenté en figure 5).

Dans l'exemple illustré, le dispositif 500 comprend en outre un circuit de commande 503 (CTRL) comportant le triac 400. Bien qu'un seul triac 400 ait été symbolisé en figure 5, le circuit de commande 503 peut bien entendu comporter au moins un autre triac analogue ou identique au triac 400. Dans l'exemple représenté, le circuit de commande 503 est relié ou connecté à la source d'énergie électrique 501. En pratique, le triac 400 est par exemple mis sous boîtier et brasé à une carte de circuit imprimé du circuit de commande 503.

Le dispositif 500 comprend par exemple en outre une charge 505 (LOAD) reliée ou connectée au circuit de commande 503. La charge 505 peut correspondre à tout type d'élément dit récepteur ou consommateur d'énergie électrique. À titre d'exemple, la charge 505 est une machine tournante, par exemple un moteur électrique, une résistance chauffante, etc.

Le circuit de commande 503 est par exemple destiné à contrôler l'alimentation électrique de la charge 505 depuis la source d'énergie électrique 501. À titre d'exemple, en fonction des besoins d'un utilisateur du dispositif 500, le circuit de commande 503 est destiné à autoriser ou à bloquer l'alimentation en énergie électrique de la charge 505 par la source 501.

À titre d'exemple, le triac 400 est utilisé dans des applications :
- de commande d'éclairage, par exemple pour contrôler la luminosité de lampes à incandescence ou de diodes électroluminescentes à gradation (« dimmable LED », en anglais), par exemple dans le domaine de l'éclairage public, de l'éclairage de scène, et dans d'autres types de systèmes d'éclairage commerciaux ;
- de commande de chauffage, par exemple pour contrôler la température de radiateurs, de fours et d'autres systèmes de chauffage ;
- de commande de moteur, par exemple pour contrôler la vitesse de moteurs à courant alternatif dans diverses applications industrielles ;
- d'alimentation électrique, par exemple pour contrôler des tensions et des courants de sortie de systèmes d'alimentation en courant alternatif ;
- dans le domaine médical, le triac 400 étant par exemple intégré dans des équipements médicaux tel que des appareils d'électrocautérisation et des défibrillateurs ; et
- dans le domaine de la domotique, le triac 400 étant par exemple intégré dans des systèmes domotiques pour contrôler divers appareils tels que des climatiseurs, des ventilateurs et des réfrigérateurs.

Un avantage du triac 400 tient au fait qu'il permet d'être utilisé en remplacement du triac 100 sans modification des caractéristiques électriques de sa région de gâchette 121. Cela permet par exemple de prévoir plusieurs variantes du dispositif 500 en fonction de la puissance électrique de la charge 505 à alimenter, par exemple une version dite « basse puissance » dans laquelle le circuit de commande 503 utilise le triac 100 et une version dite « haute puissance » dans laquelle le circuit de commande 503 utilise le triac 400, sans modification des autres éléments du circuit de commande 503.

Le dispositif 500 peut en outre comprendre d'autres éléments et/ou circuits symbolisés, en figure 5, par un unique bloc fonctionnel 507 (FCT).

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que la figure 4 prenne pour exemple un cas dans lequel le triac 400 présente une forme générale rectangulaire, les modes de réalisation non revendiqués ne se limitent pas à ce cas et s'appliquent plus généralement à toute forme de triac, par exemple ovale, circulaire, hexagonale, octogonale, etc.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Triac (400) formé dans et sur un substrat semiconducteur (101), le triac présentant, en vue de dessus, une forme sensiblement rectangulaire et comprenant :
- du côté d'une première face (101T) du substrat, une première région (105) dopée d'un premier type de conductivité et connectée à une première borne de conduction (A1) du triac ;
- du côté d'une deuxième face (101B) du substrat opposée à la première face, une deuxième région (111) dopée du premier type de conductivité et connectée à une deuxième borne de conduction (A2) du triac ; et
- une région de gâchette (121) connectée à une borne de commande (G) du triac,
dans lequel les première et deuxième régions présentent respectivement des première et deuxième faces latérales parallèles (105I, 111I), le triac comprenant, entre les première et deuxième faces latérales parallèles, une région de séparation (301) non recouverte par les première et deuxième régions, la région de séparation ayant la forme d'une bande s'étendant le long d'une première direction à l'intérieur de la région de gâchette et présentant une inflexion (401) à l'extérieur de la région de gâchette,
dans lequel la première direction est inclinée d'un angle égal à environ 45° par rapport aux côtés du rectangle formé par le triac.

2. Triac (400) selon la revendication 1, dans lequel la région de séparation (301) a, à l'extérieur de la région de gâchette (121), la forme d'une bande s'étendant le long d'une deuxième direction sensiblement parallèle à une diagonale du rectangle formé par le triac.

3. Triac (400) selon la revendication 1 ou 2, dans lequel un réseau de court-circuitage (303) est formé dans chacune des première et deuxième régions (105, 111), chaque réseau de court-circuitage comprenant au moins une tranchée traversante (305) s'étendant le long d'une troisième direction à l'intérieur de la région de gâchette (121) et présentant une inflexion (403) à l'extérieur de la région de gâchette.

4. Triac (400) selon la revendication 3, dans lequel la troisième direction est sensiblement parallèle à la première direction.

5. Triac (400) selon la revendication 3 ou 4, dans lequel, à l'extérieur de la région de gâchette (121), chaque tranchée traversante (305) s'étend le long d'une quatrième direction sensiblement parallèle à une diagonale du rectangle formé par le triac.

6. Triac (400) selon l'une quelconque des revendications 3 à 5, dans lequel chaque réseau de court-circuitage (303) comprend en outre une pluralité de vias traversants (307).

7. Triac (400) selon l'une quelconque des revendications 1 à 6, dans lequel la région de gâchette (121) présente, en vue de dessus, une forme sensiblement carrée.

8. Triac (400) selon l'une quelconque des revendications 1 à 7, dans lequel le substrat semiconducteur (101) est dopé d'un deuxième type de conductivité opposé au premier type de conductivité, les premier et deuxième types de conductivité étant respectivement le type N et le type P.

9. Dispositif (500) comprenant au moins un triac (400) selon l'une quelconque des revendications 1 à 8.

## Patentansprüche

1. Ein Triac (400), der in und auf einem Halbleitersubstrat (101) ausgebildet ist, in Draufsicht im Wesentlichen eine rechteckige Form hat und Folgendes aufweist:
- auf der Seite einer ersten Oberfläche (101T) des Substrats eine erste dotierte Region (105) eines ersten Leitfähigkeitstyps, die mit einem ersten Leitungsanschluss (A1) des Triacs verbunden ist;
- auf der Seite einer zweiten Oberfläche (101B) des Substrats, die der ersten Oberfläche gegenüberliegt, eine zweite dotierte Region (111) des ersten Leitfähigkeitstyps, die mit einem zweiten Leitungsanschluss (A2) des Triacs verbunden ist; und
- einen Gate-Bereich (121), der mit einem Steueranschluss (G) des Triacs verbunden ist,
wobei die erste und die zweite Region jeweils erste bzw. zweite parallele Seitenflächen (1051, 111I) aufweisen, wobei der Triac zwischen den ersten und zweiten parallelen Seitenflächen einen Trennbereich (301) aufweist, der nicht von der ersten und der zweiten Region bedeckt ist, wobei der Trennbereich die Form eines Streifens aufweist, der sich entlang einer ersten Richtung innerhalb des Gate-Bereichs erstreckt und außerhalb des Gate-Bereichs einen Knick (401) aufweist, wobei die erste Richtung um einen Winkel von ungefähr 45° gegenüber den Seiten des von dem Triac gebildeten Rechtecks geneigt ist.

2. Der Triac (400) nach Anspruch 1, wobei der Trennbereich (301) außerhalb des Gate-Bereichs (121) die Form eines Streifens aufweist, der sich entlang einer zweiten Richtung erstreckt, die im Wesentlichen parallel zu einer Diagonalen des von dem Triac gebildeten Rechtecks verläuft.

3. Der Triac (400) nach Anspruch 1 oder 2, wobei in jeder der ersten und zweiten Regionen (105, 111) ein Kurzschlussnetzwerk (303) ausgebildet ist, wobei jedes Kurzschlussnetzwerk wenigstens einen durchgehenden Graben (305) aufweist, der sich entlang einer dritten Richtung innerhalb des Gate-Bereichs (121) erstreckt und außerhalb des Gate-Bereichs einen Knick (403) aufweist.

4. Der Triac (400) nach Anspruch 3, wobei die dritte Richtung im Wesentlichen parallel zu der ersten Richtung verläuft.

5. Der Triac (400) nach Anspruch 3 oder 4, wobei sich außerhalb des Gate-Bereichs (121) jeder durchgehende Graben (305) entlang einer vierten Richtung erstreckt, die im Wesentlichen parallel zu einer Diagonalen des von dem Triac gebildeten Rechtecks verläuft.

6. Der Triac (400) nach einem der Ansprüche 3 bis 5, wobei jedes Kurzschlussnetzwerk (303) ferner eine Vielzahl von Durchkontaktierungen (307) aufweist.

7. Der Triac (400) nach einem der Ansprüche 1 bis 6, wobei der Gate-Bereich (121) in Draufsicht im Wesentlichen eine quadratische Form aufweist.

8. Der Triac (400) nach einem der Ansprüche 1 bis 7, wobei das Halbleitersubstrat (101) mit einem zweiten Leitfähigkeitstyp dotiert ist, der entgegengesetzt zu dem ersten Leitfähigkeitstyp ist, wobei der erste und der zweite Leitfähigkeitstyp jeweils vom Typ N und vom Typ P sind.

9. Eine Einrichtung (500), die wenigstens einen Triac (400) nach einem der Ansprüche 1 bis 8 aufweist.

## Claims

1. Triac (400) formed inside and on top of a semiconductor substrate (101), the triac having, in top view, a substantially rectangular shape and comprising:
- on the side of a first surface (101T) of the substrate, a first doped region (105) of a first conductivity type and connected to a first conduction terminal (A1) of the triac;
- on the side of a second surface (101B) of the substrate opposite to the first surface, a second doped region (111) of the first conductivity type and connected to a second conduction terminal (A2) of the triac; and
- a gate region (121) connected to a control terminal (G) of the triac,
wherein the first and second regions respectively have first and second parallel lateral surfaces (105I, 1111), the triac comprising, between the first and second parallel lateral surfaces, a separation region (301) not covered by the first and second regions, the separation region having the shape of a strip extending along a first direction inside of the gate region and exhibiting an inflection (401) outside of the gate region, wherein the first direction is inclined by an angle equal to approximately 45° with respect to the sides of the rectangle formed by the triac.

2. Triac (400) according to claim 1, wherein the separation region (301) has, outside of the gate region (121), the shape of a strip extending along a second direction substantially parallel to a diagonal of the rectangle formed by the triac.

3. Triac (400) according to claim 1 or 2, wherein a shorting network (303) is formed in each of the first and second regions (105, 111), each shorting network comprising at least one through trench (305) extending along a third direction inside of the gate region (121) and exhibiting an inflection (403) outside of the gate region.

4. Triac (400) according to claim 3, wherein the third direction is substantially parallel to the first direction.

5. Triac (400) according to claim 3 or 4, wherein, outside of the gate region (121), each through trench (305) extends along a fourth direction substantially parallel to a diagonal of the rectangle formed by the triac.

6. Triac (400) according to any of claims 3 to 5, wherein each shorting network (303) further comprises a plurality of through vias (307).

7. Triac (400) according to any of claims 1 to 6, wherein the gate region (121) has, in top view, a substantially square shape.

8. Triac (400) according to any of claims 1 to 7, wherein the semiconductor substrate (101) is doped with a second conductivity type opposite to the first conductivity type, the first and second conductivity types respectively being type N and type P.

9. Device (500) comprising at least one triac (400) according to any of claims 1 to 8.
